# EUROPEAN PATENT SPECIFICATION

(11) **EP 2 003 459 B1**
(45) Date of publication and mention of the grant of the patent: **28.08.2019**
(21) Application number: 07110005.1
(22) Date of filing: 11.06.2007
(51) Int. Cl.: G01R 31/01

(54) **Apparatus for manufacture of electronic assemblies**
Vorrichtung zur Herstellung elektronischer Anordnungen
Appareil pour la fabrication d'ensembles électroniques

(43) Date of publication of application: 17.12.2008
(73) Proprietor: BlackBerry Limited, Waterloo, ON N2K 0A7 (CA)
(72) Inventor: Gallagher, Niall, RR4, Cambridge, Ontario N1R 5S5 (CA); Toth, Ted, Ontario N2P 2V6 (CA)
(74) Representative: Roberts, Gwilym Vaughan

(56) References cited:
- DE-C1- 19 617 537
- US-A1- 2006 283 688

## Description

### TECHNICAL FIELD OF THE APPLICATION

The present disclosure generally relates to the manufacturing of electronic apparatuses. More particularly, and not by way of any limitation, the present disclosure is directed to a manufacturing cell designed to optimize space within a manufacturing facility.

### BACKGROUND

Despite significant advances in manufacturing technology, assembly and testing of electronic assemblies require the use of equipment consuming substantial quantities of factory floor space. Testing and characterization of electronic assemblies, for example, generally requires physically large machines, each of which consumes significant floor space within a factory. It is, therefore, desirable to minimize the size and complexity of electronic apparatus manufacturing cells, including electronic assembly testing cells.

DE19617537 discloses a device having a feed unit for accepting a number of transponders for testing. The feed unit has a filling aperture and an outlet aperture. A vertical transport unit has a diamagnetic hollow body, an inlet connected to the feed unit output, a transponder separator, a holding device for interrupting the movement and positioning of the transponders, and an outlet opening. A measurement unit with several coils encloses the transport unit, and performs a measurement process on each transponder positioned by the holding device. A control unit controls the measurement process and evaluates the results.

US 2006/0283688 relates to embodiments of a substrate handling system provided herein. In one embodiment apparatus for handling a substrate includes a conveyor having a plurality of rollers arranged to convey a substrate thereon and a substrate handler. The substrate handler includes a first bracket and a first plurality of fingers horizontally from the first bracket. The first plurality of fingers has a substrate support surface and is disposed between adjacent ones of the plurality of rollers. The substrate handler is movable between an idle position having the first plurality of fingers disposed beneath a support elevation of the plurality of rollers, and a transfer position having the first plurality of fingers disposed above the plurality of rollers.

### SUMMARY OF THE DISCLOSURE

The invention is defined in the independent claim. Some optional features are defined in the dependent claims.

### BRIEF DESCRIPTION OF THE DRAWINGS

A more complete understanding of the embodiments of the present disclosure may be had by reference to the following Detailed Description when taken in conjunction with the accompanying drawings wherein:
Figure 1 is a front view of an electronic apparatus manufacturing cell;
Figure 2 is an end view of the electronic apparatus manufacturing cell;
Figure 3 is an overhead plan view of the electronic apparatus manufacturing cell;
Figure 4 is an overheard plan view of the electronic apparatus manufacturing cell showing an electronic apparatus at the entry end of the infeed conveyor;
Figure 5 is an overheard plan view of the electronic apparatus manufacturing cell showing an electronic apparatus at the exit end of the infeed conveyor;
Figure 6 is an overheard plan view of the electronic apparatus manufacturing cell showing an electronic apparatus at the entry end of the pass conveyor;
Figure 7 is an overheard plan view of the electronic apparatus manufacturing cell showing an electronic apparatus at the exit end of the pass conveyor;
Figure 8 is an overheard plan view of the electronic apparatus manufacturing cell showing an electronic apparatus at the entry end of the reject conveyor;
Figure 9 is an overheard plan view of the electronic apparatus manufacturing cell showing an electronic apparatus at the exit end of the reject conveyor; and
Figure 10 is an overhead plan view of a set of three electronic apparatus manufacturing cells arranged in series.

### DETAILED DESCRIPTION OF THE DRAWINGS

An apparatus of the present disclosure will now be described with reference to various examples of how the embodiments can best be made and used. Identical reference numerals are used throughout the description and several views of the drawings to indicate identical or corresponding parts, wherein the various elements are not necessarily drawn to scale.

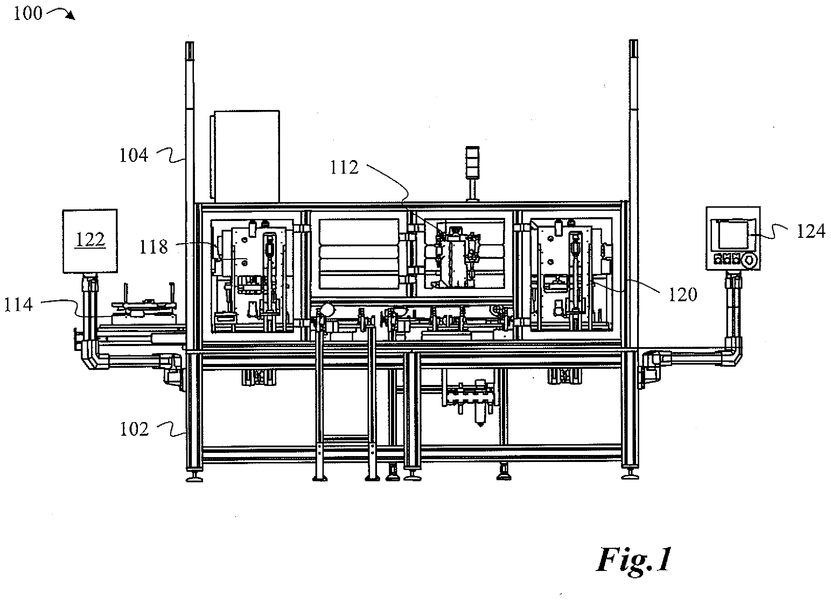

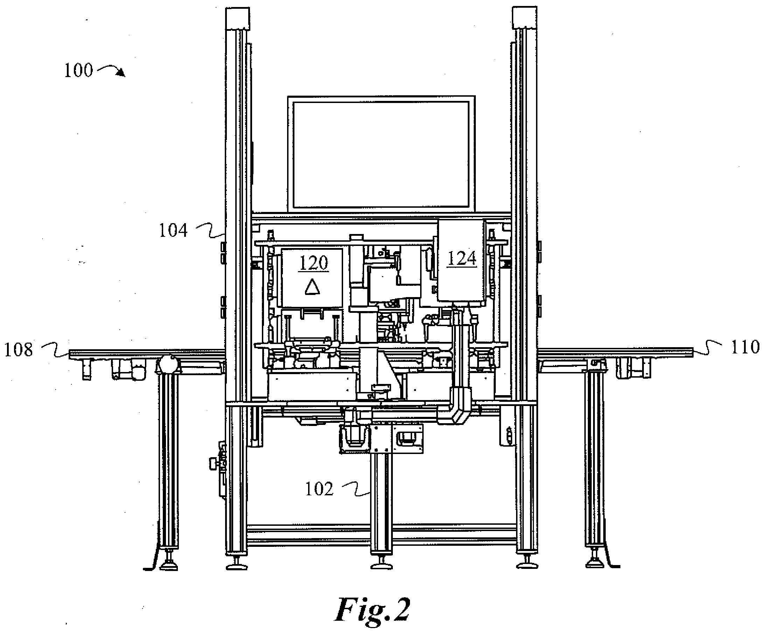

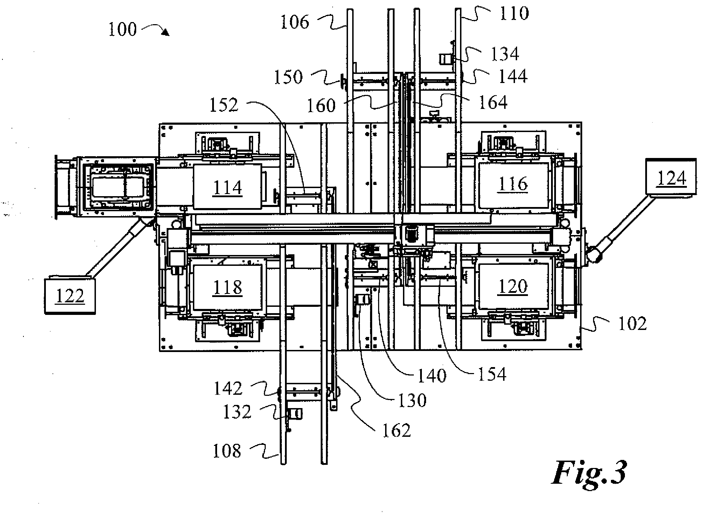

Figures 1-3 depict an electronic apparatus manufacturing cell 100 having a lower frame 102 and an upper frame 104. Lower frame 102 supports an infeed conveyor 106, a pass conveyor 108 and a reject conveyor 110. A transfer robot 112 is disposed above conveyors 106, 108, 110 and is equipped with an end effector suitable for apprehending an electronic apparatus undergoing processing and transferring it from one of conveyors 106, 108, 110 to another of conveyors 106, 108, 110. Although the present disclosure is presented in connection with an electronic apparatus testing cell for purposes of illustration, those of skill in the art will appreciate that the present disclosure will apply in like manner to a variety of other types of electronic apparatus manufacturing cells.

The determination as to the destination conveyor for an electronic apparatus undergoing processing may be made according to the results of tests performed using one or more of stations 114, 116, 118, 120. An electronic apparatus is brought into the electronic apparatus manufacturing cell 100 on infeed conveyor 106, processed using one or more of stations 114, 116, 118, 120, and then transferred to the appropriate outfeed conveyor according to the outcome of the processing. An electronic apparatus successfully passing through one or more processes performed at one or more of stations 114, 116, 118, 120 may be transferred to pass conveyor 108 and transferred to the next cell in the manufacturing facility. An electronic apparatus unsuccessfully completing one or more processes performed at one or more of stations 114, 116, 118, 120 may be transferred to reject conveyor 110 and transferred to the previous cell in the manufacturing facility. In certain embodiments, all of stations 114, 116, 118, 120 may be testing stations. In other embodiments, all of stations 114, 116, 118, 120 may be manufacturing stations. Other embodiments may incorporate a combination of manufacturing stations and testing stations, and certain stations may combine manufacturing capability and testing capability in a single station.

In certain embodiments, an electronic apparatus may be processed at a first station 114, 116, 118, 120 and then moved to a second station 114, 116, 118, 120 or a conveyor 108, 110 within electronic apparatus manufacturing cell 100 according to the outcome of the processing at the first station 114, 116, 118, 120. An assembly may, for example, be initially moved to station 114, where testing is performed on the assembly. If the testing is successful, the assembly may be moved to station 116 for additional testing or other processing. If the testing is unsuccessful, the assembly may be moved to station 118 for further testing or placed on reject conveyor 110. A wide variety of other possibilities will be apparent to those of skill in the art.

In certain embodiments, all assemblies passing through electronic apparatus manufacturing cell 100 must pass through each of stations 114, 116, 118, 120 for processing before proceeding to the next cell in the line. In other embodiments, stations 114, 116, 118, 120 are identical to one another, and assemblies are moved to stations 114, 116, 118, 120 according to which of stations 114, 116, 118, 120 are available at a given time. In certain embodiments, stations 114, 116, 118, 120 are specific to certain assembly designs, and an electronic apparatus may be moved to one or more stations 114, 116, 118, 120 within electronic apparatus manufacturing cell 100 according to the type or model of the electronic apparatus. With this capability, a variety of types of electronic apparatuses may be processed within a single apparatus.

Electronic apparatus manufacturing cell 100 interacts with its human operators via operator interface panels 122 and 124. Generally, operator interface panels 122 and 124 will incorporate visual displays and operator input controls such as those shown on operator interface panel 124 in figure 1. Operator interface panels 122 and 124 may also incorporate audio outputs in order to capture the operator's attention when the operator is not looking at the visual display.

Each of conveyors 106, 108, 110 has the same general construction and each of conveyors 106, 108, 110 is driven independently by a single conveyor motor 130, 132, 134, respectively. Each conveyor motor 130, 132, 134 powers a driving jackshaft 140, 142, 144, respectively. Each driving jackshaft 140, 142, 144 drives a driven jackshaft 150, 152, 154 through a drive belt 160, 162, 164. Together, each pair of driving jackshafts 140, 142, 144 and driven jackshafts 150, 152, 154 impels the payload interface surface (not shown) for each conveyor 106, 108, 110. The payload interface surface may vary by application, but will generally be a belt, chain or cable.

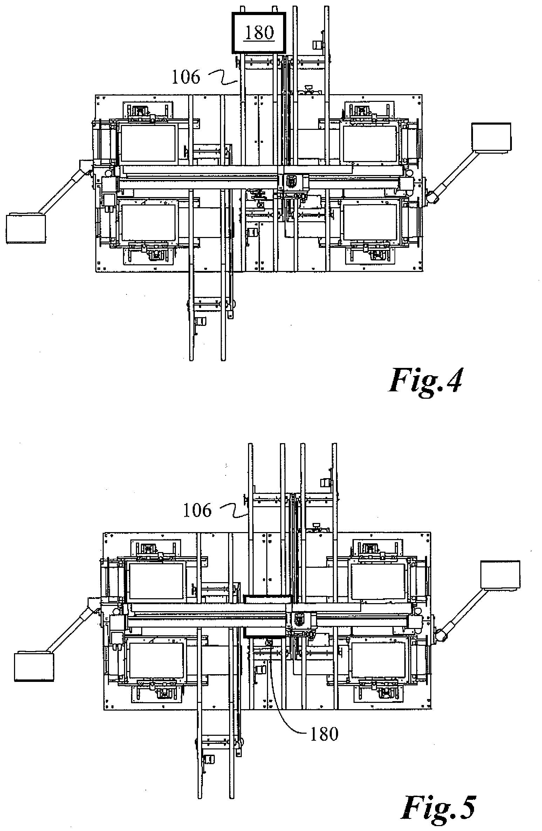

Figures 4 and 5 depict an electronic apparatus 180 entering electronic apparatus manufacturing cell 100 on infeed conveyor 106. In figure 4, the electronic apparatus 180 is disposed at the entry end of infeed conveyor 106. In normal operation, infeed conveyor 106 will draw electronic apparatus 180 into the central portion of electronic apparatus manufacturing cell 100, where it can be processed. Figure 5 shows the position of the electronic apparatus 180 after infeed conveyor 106 has been powered to draw electronic apparatus into the central portion of electronic apparatus manufacturing cell 100.

Those of skill in the art will note that electronic apparatus 180 is shown as being generally rectangular, having a longer dimension disposed perpendicularly to the direction of travel of conveyors 106, 108, 110. Alternate embodiments may be designed to accept electronic apparatuses having their longer dimension disposed parallel to the direction of conveyor travel or in some other orientation. Certain embodiments may incorporate a transfer robot 112 having the capability to reorient electronic apparatuses about one or more axes, thereby removing any necessity that the orientation of the incoming electronic apparatuses match the orientation of the stations 114, 116, 118, 120. In one such embodiment, electronic apparatuses such as electronic apparatus 180 may enter electronic apparatus manufacturing cell 100 oriented with their longer axis aligned to the direction of travel of the conveyors, then reoriented by transfer robot 112 to a different orientation matching the orientation of one of stations 114, 116, 118, 120. Subsequent to processing by that station, transfer robot 112 may again reorient electronic apparatus 180 to an orientation matching a different one of stations 114, 116, 118, 120 or one of conveyors 16, 108, 110. In the illustrated embodiment, for example, assemblies entering electronic apparatus manufacturing cell 100 could enter oriented with their longer axis aligned to the direction of travel of the conveyors. In this case, they may not be properly oriented to interface with stations 114, 116, 118 120, which are oriented to interface with assemblies having their longer dimension disposed orthogonally to the direction of travel of the conveyors. In such a case, it would be necessary to reorient the assemblies 90 degrees about the vertical axis in order to insert them into one of stations 114, 116, 118, 120. If the assemblies are reoriented in this manner, it may then be necessary to reorient them after processing but prior to placement on one of conveyors 106, 108, 110. As above, a wide variety of possibilities will be apparent to those of skill in the art.

After the electronic apparatus 180 is drawn into the electronic apparatus manufacturing cell 100 on infeed conveyor 106, the electronic apparatus is processed using one or more of stations 114, 116, 118, 120. After the processing is complete, a determination may be made as to whether electronic apparatus 180 should be forwarded to the next manufacturing cell via pass conveyor 108 or returned to the prior manufacturing cell via reject conveyor 110. After this determination is made, transfer robot 112 is actuated to move the electronic apparatus to the appropriate outfeed conveyor 108 or 110.

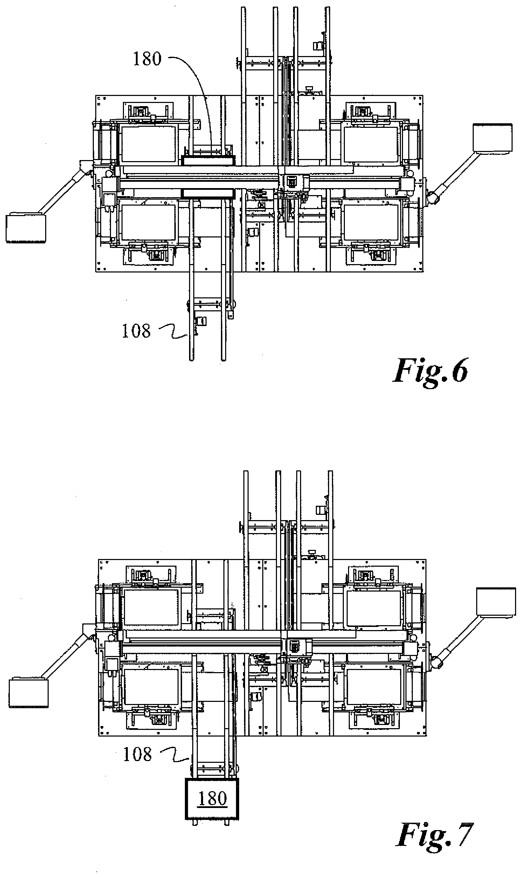

Figures 6 and 7 show an electronic apparatus 180 disposed on pass conveyor 108. In figure 6, the electronic apparatus 180 has been placed on pass conveyor 108 for transfer to the next manufacturing cell. Figure 7 shows the position of electronic apparatus 180 after pass conveyor 108 has been actuated in order to transfer electronic apparatus 180 to the next manufacturing cell.

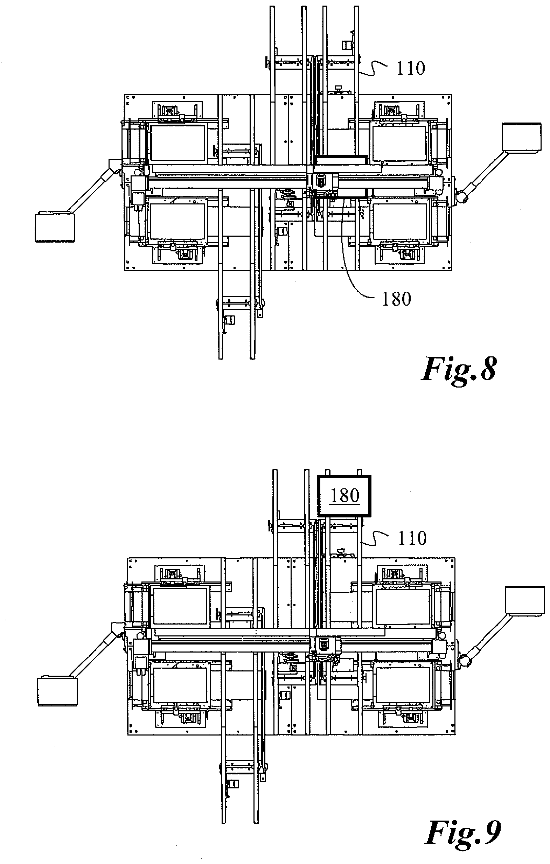

Figures 8 and 9 show an an electronic apparatus 180 disposed on pass conveyor 108. In figure 8, the electronic apparatus 180 has been placed on reject conveyor 110 for transfer to the previous manufacturing cell. Figure 9 shows the position of electronic apparatus 180 after reject conveyor 110 has been actuated in order to transfer electronic apparatus 180 to the previous manufacturing cell in the manufacturing line.

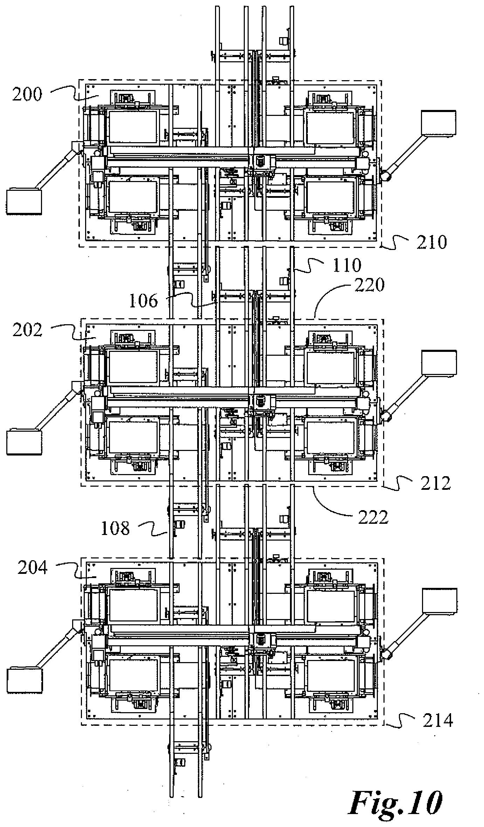

Those of skill in the art will note that conveyors 106, 108, 110 of each cell 100 extend well beyond the envelopes of a cell defined by the boundaries of frames 102 and 104. This design allows electronic apparatus manufacturing cell 100 to be disposed immediately adjacent to the manufacturing cells disposed before and after electronic apparatus manufacturing cell 100 without the need for intermediate conveyor units between the cells. Figure 10 shows a set of three processing cells 200, 202, 204 disposed immediately adjacent to one another. The frames 102 and 104 of cells 200, 202, 204 define rectangular envelopes 210, 212, 214, respectively. The conveyors 106, 108, 110 of each cell 200, 202, 204 extend through the envelope 210, 212, 214 for the cell 200, 202, 204 to the adjacent cell 200, 202, 204. Conveyors 106 and 110 of cell 202, for example, extend through side 220 of envelope 212 and up to envelope 210 of cell 200. Conveyor 108 of cell 202 extends through side 222 of envelope 212 and up to envelope 214 of cell 204. It can be seen that no additional intermediate conveyors are necessary in order to transfer electronic components between processing cells 200, 202, 204.

It is believed that the operation and construction of the embodiments of the present disclosure will be apparent from the Detailed Description set forth above. While the exemplary embodiments shown and described may have been characterized as being preferred, it should be readily understood that various changes and modifications could be made therein without departing from the scope of the present disclosure as set forth in the following claims.

## Claims

1. An electronic apparatus manufacturing cell (100) defining an electronic apparatus manufacturing cell envelope having a lower frame (102); an upper frame (104) supported by the lower frame, the upper frame comprising a first side and a second opposing side, the first side and second opposing side of the upper frame together defining boundaries of the cell envelope; the electronic apparatus manufacturing cell (100) comprising:
an infeed conveyor (106) supported on the lower frame and having a first end situated outside of the cell envelope beyond the first side of the upper frame, and a second end situated inside the cell envelope and proximal to the second opposing side of the upper frame, the infeed conveyor extending from a point outside of the electronic apparatus manufacturing cell envelope on the first side to a point inside of the envelope;
a pass conveyor (108) supported by the lower frame and situated parallel and adjacent to the infeed conveyor, the pass conveyor having a first end situated inside the cell envelope and proximal to the first side of the upper frame, and a second end situated outside of the cell envelope beyond the second opposing side of the upper frame; the pass conveyor extending from a point inside the electronic apparatus manufacturing cell envelope to a point outside of the electronic apparatus manufacturing cell envelope; and
a processing station for processing an electronic apparatus within the manufacturing cell;
means for transferring the electronic apparatus between the infeed conveyor, the processing station, and
a reject conveyor (110), extending from a point inside the electronic apparatus manufacturing cell envelope to a point outside of the electronic apparatus manufacturing cell envelope.

2. The electronic apparatus manufacturing cell (100) of claim 1, wherein each one of the infeed, and pass conveyors is arranged to be driven independently by a respective single conveyor motor.

3. The electronic apparatus manufacturing cell (100) of claim 1 wherein the cell comprises two or more processing stations (114, 116, 118, 120).

4. The electronic apparatus manufacturing cell (100) of claim 1 wherein the cell comprises four processing stations (114, 116, 118, 120).

5. The electronic apparatus manufacturing cell (100) of claim 1 wherein the cell comprises an actuator (112) having an end effector secured thereto, operable to move an electronic apparatus from one of the conveyors (106, 108, 110) to a different one of the conveyors (106, 108, 110).

6. The electronic apparatus manufacturing cell (100) of claim 1 wherein the electronic apparatus manufacturing cell envelope comprises a rectangular shape.

7. The electronic apparatus manufacturing cell (100) of claim 1 wherein the electronic apparatus manufacturing cell envelope has six sides, and wherein the first side and second side have rectangular shapes.

8. The electronic apparatus manufacturing cell (100) as claimed in claim 1 in which the reject conveyor (110) is disposed adjacent to the infeed conveyor (106).

## Patentansprüche

1. Fertigungszelle (100) für elektronische Vorrichtungen, die eine Fertigungszellhülle für elektronische Vorrichtungen definiert mit einem unteren Rahmen (102); einem oberen Rahmen (104), der von dem unteren Rahmen gehalten wird, wobei der obere Rahmen eine erste Seite und eine zweite gegenüberliegende Seite umfasst, wobei die erste Seite und die zweite gegenüberliegende Seite des oberen Rahmens zusammen Grenzen der Zellhülle definieren; wobei die Fertigungszelle (100) für elektronische Vorrichtungen folgendes umfasst:
ein Einlaufförderer (106), der auf dem unteren Rahmen gehalten wird und ein erstes Ende aufweist, das außerhalb der Zellhülle über die erste Seite des oberen Rahmens hinaus angeordnet ist, und ein zweites Ende, das innerhalb der Zellhülle und proximal zur zweiten gegenüberliegenden Seite des oberen Rahmens angeordnet ist, wobei sich der Einlaufförderer von einem Punkt außerhalb der Zellhülle der elektronischen Vorrichtung auf der ersten Seite zu einem Punkt innerhalb der Hülle erstreckt;
ein Durchgangsförderer (108), der vom unteren Rahmen gehalten wird und parallel und angrenzend an den Einlaufförderer angeordnet ist, wobei der Durchgangsförderer ein erstes Ende aufweist, das innerhalb der Zellhülle und proximal zur ersten Seite des oberen Rahmens angeordnet ist, und ein zweites Ende, das außerhalb der Zellhülle über die zweite gegenüberliegende Seite des oberen Rahmens hinaus angeordnet ist; wobei sich der Durchgangsförderer von einem Punkt innerhalb der Zellhülle der elektronischen Vorrichtung zu einem Punkt außerhalb der Fertigungszellhülle der elektronischen Vorrichtung erstreckt; und
eine Bearbeitungsstation zum Bearbeiten einer elektronischen Vorrichtung innerhalb der Fertigungszelle;
Mittel zum Übertragen der elektronischen Vorrichtung zwischen dem Einlaufförderer, der Bearbeitungsstation, und
einem Ausschussförderer (110), der sich von einem Punkt innerhalb der Fertigungszellhülle für elektronische Vorrichtungen bis zu einem Punkt außerhalb der Fertigungszellhülle der elektronischen Vorrichtung erstreckt.

2. Die Fertigungszelle (100) für elektronische Vorrichtungen gemäß Anspruch 1, wobei jeder der Einlauf- und Durchgangsförderer so angeordnet ist, dass er unabhängig von einem jeweiligen einzelnen Fördermotor angetrieben wird.

3. Die Fertigungszelle (100) für elektronische Vorrichtungen gemäß Anspruch 1, wobei die Zelle zwei oder mehr Bearbeitungsstationen (114, 116, 118, 120) umfasst.

4. Die Fertigungszelle (100) für elektronische Vorrichtungen gemäß Anspruch 1, wobei die Zelle vier Bearbeitungsstationen (114, 116, 118, 120) umfasst.

5. Die Fertigungszelle (100) für elektronische Vorrichtungen gemäß Anspruch 1, wobei die Zelle ein Aktuator (112) mit einem daran befestigten Endeffektor umfasst, der so betrieben werden kann, dass er eine elektronische Vorrichtung von einem der Förderer (106, 108, 110) zu einem anderen der Förderer (106, 108, 110) bewegt.

6. Die Fertigungszelle (100) für elektronische Vorrichtungen gemäß Anspruch 1, wobei die Fertigungszellhülle für elektronische Vorrichtungen eine rechteckige Form aufweist.

7. Die Fertigungszelle (100) für elektronische Vorrichtungen gemäß Anspruch 1, wobei die Fertigungszellhülle für elektronische Vorrichtungen sechs Seiten aufweist und wobei die erste Seite und die zweite Seite rechteckige Formen aufweisen.

8. Die Fertigungszelle (100) für elektronische Vorrichtungen gemäß Anspruch 1, in der der Ausschussförderer (110) angrenzend an den Einlaufförderer (106) angeordnet ist.

## Revendications

1. Cellule de fabrication d'appareil électronique (100) définissant une enveloppe de cellule de fabrication d'appareil électronique comportant un bâti inférieur (102) ; un bâti supérieur (104) supporté par le bâti inférieur, le bâti supérieur comprenant un premier côté et un deuxième côté opposé, le premier côté et le deuxième côté opposé du bâti supérieur définissant ensemble des limites de l'enveloppe de cellule ; la cellule de fabrication d'appareil électronique (100) comprenant :
un convoyeur de délivrance d'entrée (106) supporté sur le bâti inférieur, et comportant une première extrémité située à l'extérieur de l'enveloppe de cellule au-delà du premier côté du bâti supérieur, et une deuxième extrémité située à l'intérieur de l'enveloppe de cellule et proximale vis-à-vis du deuxième côté opposé du bâti supérieur, le convoyeur de délivrance d'entrée s'étendant d'un point à l'extérieur de l'enveloppe de cellule de fabrication d'appareil électronique sur le premier côté à un point à l'intérieur de l'enveloppe ;
un convoyeur de passage (108) supporté par le bâti inférieur et situé parallèlement et adjacent au convoyeur de délivrance d'entrée, le convoyeur de passage comportant une première extrémité située à l'intérieur de l'enveloppe de cellule et proximale vis-à-vis du premier côté du bâti supérieur, et une deuxième extrémité située à l'extérieur de l'enveloppe de cellule au-delà du deuxième côté opposé du bâti supérieur ; le convoyeur de passage s'étendant d'un point à l'intérieur de l'enveloppe de cellule de fabrication d'appareil électronique à un point à l'extérieur de l'enveloppe de cellule de fabrication d'appareil électronique ; et
une station de traitement pour traiter un appareil électronique à l'intérieur de la cellule de fabrication ;
des moyens pour transférer l'appareil électronique entre le convoyeur de délivrance d'entrée, la station de traitement, et
un convoyeur de rejet (110), s'étendant d'un point à l'intérieur de l'enveloppe de cellule de fabrication d'appareil électronique à un point à l'extérieur de l'enveloppe de cellule de fabrication d'appareil électronique.

2. Cellule de fabrication d'appareil électronique (100) selon la revendication 1, dans laquelle chacun des convoyeurs de délivrance d'entrée et de passage est agencé de façon à être entraîné indépendamment par un moteur de convoyeur unique respectif.

3. Cellule de fabrication d'appareil électronique (100) selon la revendication 1, où la cellule comprend deux ou plus de deux stations de traitement (114, 116, 118, 120) .

4. Cellule de fabrication d'appareil électronique (100) selon la revendication 1, où la cellule comprend quatre stations de traitement (114, 116, 118, 120).

5. Cellule de fabrication d'appareil électronique (100) selon la revendication 1, où la cellule comprend un actionneur (112) ayant un effecteur d'extrémité fixé à celle-ci, ayant pour fonction de déplacer un appareil électronique de l'un des convoyeurs (106, 108, 110) à un convoyeur différent parmi les convoyeurs (106, 108, 110).

6. Cellule de fabrication d'appareil électronique (100) selon la revendication 1, dans laquelle l'enveloppe de cellule de fabrication d'appareil électronique comprend une forme rectangulaire.

7. Cellule de fabrication d'appareil électronique (100) selon la revendication 1, dans laquelle l'enveloppe de cellule de fabrication d'appareil électronique comporte six côtés, et dans laquelle le premier côté et le deuxième côté ont des formes rectangulaires.

8. Cellule de fabrication d'appareil électronique (100) selon la revendication 1, dans laquelle le convoyeur de rejet (110) est disposé adjacent au convoyeur de délivrance d'entrée (106).
